# EUROPEAN PATENT SPECIFICATION

(11) **EP 4 673 963 B1**
(45) Date of publication and mention of the grant of the patent: **18.03.2026**
(21) Application number: 25724831.0
(22) Date of filing: 16.05.2025
(51) Int. Cl.: H01J 7/18, B01D 53/04, H01L 23/26

(54) **FLEXIBLE AND MODULAR GETTER ASSEMBLY**
FLEXIBLE UND MODULARE GETTERANORDNUNG
ENSEMBLE PIÈGE À GAZ FLEXIBLE ET MODULAIRE

(30) Priority: 21.05.2024 IT 202400011437
(43) Date of publication of application: 07.01.2026
(73) Proprietor: Saes Getters S.p.A., 20045 Lainate (MI) (IT)
(72) Inventor: DI GIACOMO, Lorenzo, 67051 Avezzano AQ (IT); CARBONE, Crescenzo, 03036 Isola del Liri FR (IT); GIORGI, Stefano, 20853 Biassono MB (IT); MAURI, Luca, 20811 Cesano Maderno MB (IT); FERRARA, Alessandro, 20034 S. Giorgio su Legnano MI (IT); CORAZZA, Alessio, 22100 Como CO (IT)
(74) Representative: Novagraaf Group
(86) International application number: PCT/EP2025/063578
(87) International publication number: WO 2025/242572

(56) References cited:
- GB-A- 1 455 908
- US-A- 3 225 910
- US-A- 4 146 497
- US-B2- 9 027 546
- MAURI LUCA ET AL: "Evolution of Getter Technology in Electronic Hermetic Packaging", 2023 24TH EUROPEAN MICROELECTRONICS AND PACKAGING CONFERENCE & EXHIBITION (EMPC), IMAPS-EUROPE, 11 September 2023 (2023-09-11), pages 1 - 6, XP034541038, DOI: 10.23919/EMPC55870.2023.10418413
- SANTUCCI ALESSIA ET AL: "Novel Non-Evaporable Getter Materials and Their Possible Use in Fusion Application for Tritium Recovery", MOLECULES, vol. 25, no. 23, 1 December 2020 (2020-12-01), CH, pages 5675, XP093234412, ISSN: 1420-3049, DOI: 10.3390/molecules25235675

## Description

The present invention relates to a getter assembly comprising a flexible metallic base for a plurality of interconnected units filled with non-evaporable getter powder.

Getter materials have proved to be extremely advantageous or even essential in all industrial and commercial applications wherein the maintenance of vacuum and, more in general, a controlled atmosphere is required.

In order to allow their effective and wider use, the sorbing properties of the getter materials have to be excellent as regards the removal of gas species such as oxygen, hydrogen, nitrogen, water, carbon oxide and Volatile Organic Compounds (VOCs), thus eliminating residual gases in devices under vacuum or contaminating gases from the gaseous mixture that is present within the volume in which a controlled atmosphere must be maintained. Generally, getters are incorporated in vacuum electron tubes (such as x-ray tubes, traveling wave tubes, thermo-ionic emission tubes, etc.), in vacuum insulated devices, in sensors with vacuum jackets (such as IR sensors, pressure sensors, etc.), in MEMs (such as MEM gyroscopes), in discharge lamps with vacuum or gas-filled jackets, in hermetically sealed electronic and optoelectronic systems (such as RF devices, optical transceivers, etc.) and often more getter components must be introduced in a single apparatus.

Consequently, one of the main requests in the field of getter devices is to increase the absorbing performance or maintaining high performances with respect to the possible different applications. Usually, this is achieved using an approach based on the increase of the getter device performance, generally increasing the amount of getter material and consequently the dimensions of the getter device, and/or increasing its external surface exposed to the volume to be evacuated or "gas purified".

However, by scaling the volume faster than the surface, gas diffusivity effects toward the core of the getter devices predominate. As a consequence, it is preferable that the getter structures undergo a stretching and a losing of high-symmetry geometries (closer to a sphere). Thus, solutions with toroidal, discoidal or stretched surfaces, such as laminates, prevail in order to maintain good getter performance.

However, the stretching of the getter structure or its volume cannot be increased above a certain level because of the geometry and size constraints of the final apparatus in which said getters should be placed.

Thus, a solution according to the present invention characterized by a modular getter assembly of at least two interconnected sorbing units allows to control the amount of getter and the relative absorbing capacity without increasing the volume-to-surface ratio and bulkiness of the gettering element.

A further issue that needs to be addressed in the field of getter devices is related to specific geometric constraints or shapes of the final apparatus, such as tubular systems, in which the getters must be used.

Patent CN101706323 discloses, for example, the use of a structure of multiple getters in an infrared detector Dewar with a configuration characterized by a rigid structure with consequent tight geometric constraints.

On the contrary, our invention herein disclosed overcomes this prior art problem thanks to a flexible planar structure, in particular when characterized by multiple degrees of freedom, which can be modeled in several different configurations depending on the geometry of the final apparatus in which the getter assembly needs to be placed.

Moreover, the aforementioned Chinese patent discloses a solution wherein each getter unit is directly mounted on the body of the final apparatus with a consequent risk of particles loss when mounting each unit. On the contrary, in our invention only the common base of the interconnected units is attached to the apparatus without the need of directly involving the single units, with a high impact on the reduction of the risks of cracks and particle loss of the getter powders since only one mounting operation is required to mount multiple getter units.

Also US20120049729 discloses a getter assembly comprising a plurality of getters and a support structure; however, said getter assembly requires the presence of a getter chamber and a non-flexible structure. Specifically, the plurality of support bars may comprise a first and second elastic deformation part disposed at opposite ends of the support bars and a getter fixing part disposed between the first and second elastic deformation part. Therefore, as it is clearly disclosed in the figures of said US application, the main scaffold is rigid with reduced possible deformations of some support bases, whereas in the presently claimed invention the flexible getter assembly is directly adaptable to the surface of the final apparatus without the requirement of specific getter chambers or modifications.

GB1455908, US9027546 and US4146497, in the name of the applicant, and US3225910 disclose getter devices which consist in the repetition of interconnected free cells having well defined distances, dimensions and spatial distribution. However, even if in this case the substrate is not rigid, the cellular metallic structure is not suitable to obtain a modular getter suitable to cope with specific geometrical constraints or needs in the vacuum systems, such as customized 3D-distribution of the getters, distribution of the cells at different distances and positions or the possibility to customize tabs integrated in the structure.

A further relevant aspect of the invention is the presence of multiple interconnected units, resulting in a flexible structure which overcomes the drawbacks of assembly solutions as the one disclosed in GB980847. Indeed, the presence of single units brings a further advantage in terms of tailoring and customizing the getter assembly according to the final application, since it is possible to fill the frames of the different units with different non-evaporable getter material powders depending on the gases to be absorbed, such as hydrogen, carbon oxide or nitrogen, and on all the possible required operating conditions, for example the requirement to use different getter materials that can be selected as a function of their best operation temperature if the achieved temperatures in the device are dependent on the positions.

Finally, a widely known need in the industrial world is represented by the containment of encumbrances in shipments, the need to simplify the transport of materials and consequently reduce the environmental impact and costs of transport.

Thus, the planar configuration through which the getter assemblies herein disclosed are shipped overcomes this drawback, by minimizing the handling operations and optimizing the space.

Hence, in order to overcome all the prior art drawbacks and to realize a getter system characterized by a high level of performance, compatibility and versatility, it is herein claimed a getter assembly comprising a flexible metallic base carrying at least two interconnected units, each unit including a frame filled with a compressed powder of a non-evaporable getter material, said metallic base having specific material properties and thickness range as defined in claim 1.
Figures 1 to 12 are schematic views of possible alternatives of the modular getter assembly obtained with the flexible metallic base carrying at least two interconnected sorbing units.
Figures 1-3 show linear assemblies that can be used as a linear strip or folded according to the geometrical constraints of the final apparatus.
Figures 4-6 show planar assemblies according to the present invention.
Figure 7 shows three assemblies similar to that of Fig.5 stacked and connected by mechanical restraints.
Figures 8-9 show annular 3D assemblies according to the present invention.
Figures 10-12 show assemblies that can be easily folded to create three-dimensional structures, suitable to locate the getter units in several different positions inside the volumes of the apparatus.
Figures 13-14 show the three-dimensional structures respectively corresponding to the assemblies of figures 10 and 11.
Figure 15 shows a preassembled kit comprising several assemblies according to the embodiments of figures 3, 4, 5 and 10.

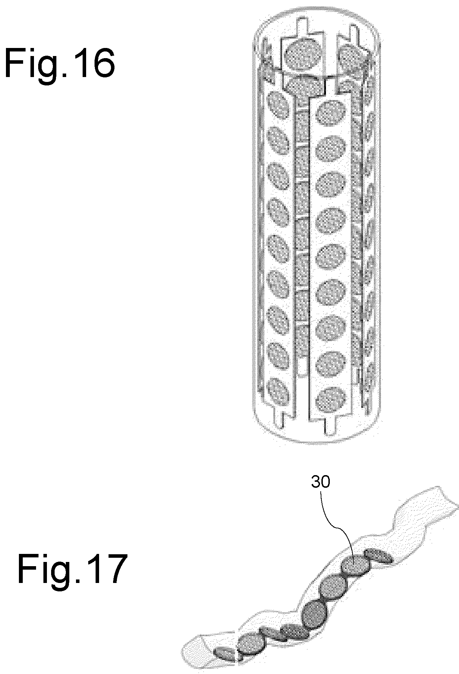

Figure 16 shows a cylindrical chamber with linear assemblies such as those of Figure 1 placed along its wall.
Figures 17 and 18 respectively show a tubular portion with a non-linear profile and a non-planar chamber containing planar assemblies similar to those of figures 2 and 3.
Figures 19 and 20 show cylindrical or polygonal chambers containing 3D assemblies similar to those of figures 7 and 9, that can be placed close to the upper or lower walls (see as example Fig.19) or on the lateral walls (see as example Fig.20).
Figure 21 is a view similar to Fig.1 showing a linear strip that is provided with holes/recesses that facilitate the folding of the strip.

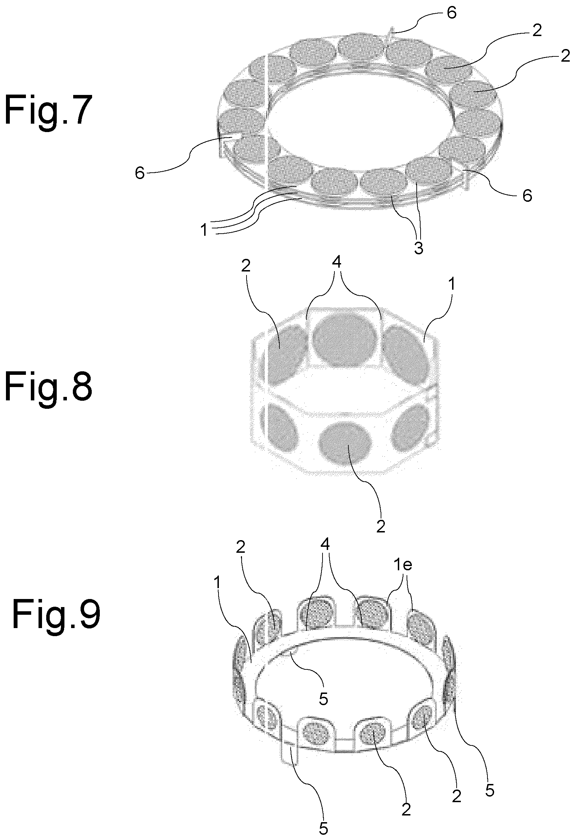

Each assembly according to the present invention essentially comprises a flexible metallic base 1 carrying a plurality of sorbing units connected thereto, wherein each of said sorbing units includes a compressed powder of a non-evaporable getter material 2 contained in a frame 3 having a volume comprised between 2 mm³ and 200 mm³, preferably between 2.5 mm³ and 100 mm³, with a shape as needed, typically a circular, oval, rectangular, squared, or general polygonal shape. The base 1 is preferably provided with one or more degrees of freedom, preferably through grooves 4 or similar features (e.g. thinner sections) located between the sorbing units and/or between sorbing units and coupling elements through which the assembly can be connected to other assemblies and/or to the apparatus which requires the getter activity, so that it can be bent to form predefined shapes, e.g. the polygonal ring of Fig.8.

The assembly is also preferably provided with at least two coupling elements 5 through which the assembly can be connected to other assemblies and/or to the apparatus which requires the getter activity.

A groove is defined as a channel or indentation created on the surface of the metallic base 1. It is typically used to create a localized area of weakness or a stress concentrator that allows the metal to bend more easily at that specific location.

A groove provides a controlled area where the metal will bend more easily while maintaining the structural integrity of the getter assembly, i.e. it is not designed for cutting away or singulation of the getter elements of the assembly. Grooving can be useful when working with materials that have relatively high strength and low ductility, as it allows for more precise control over the bending process without affecting the overall integrity of the strip.

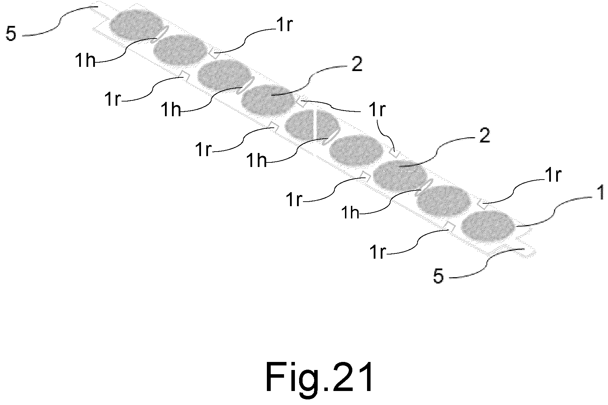

A groove 4 essentially reduces the local thickness/width of the metallic base 1, which makes it easier to bend or fold. However, the ratio between the base thickness and the groove depth varies depending on the "properties of the material, its overall strength, and the desired bending angle. Specifically, the groove depth D is critical to ensure that the material bends at the correct location without over-deforming. According to the present invention, the groove depth D is comprised between 40% and 100% of the metallic base thickness. It is to be underlined that in case of 100% depth a hole is created in the metallic base 1, such hole can be located on the boundaries of the metallic base 1, thus forming a peripheral recess 1r, or within it thus forming a proper hole 1h (see Fig.21). The groove extension E should be between 20% and 100% of the metallic base width. Moreover, in order to achieve a good compromise between integrity of the metallic base 1 and enhanced flexibility, the sum of D and E is comprised between 60% and 180%.

The flexibility of the metallic base 1 refers to the ability of a material to bend, twist or stretch without breaking and to keep the shape. Specifically, the flexible structure should be based on materials with a suitable combinations of thickness, Young's modulus (related to stiffness), yield strength (related to resistance to deformation) and ductility (ability to bend without cracking). Moreover, the flexible structure according to the present invention has been proven to be able to withstand thermal treatment at high temperatures, specifically temperatures above 500°C, without deformation. Such high temperature resistance is an important element for the present invention as often getter materials need to undergo a thermal treatment to be activated or re-activated, and therefore solutions made according to the present invention are not dependent on the getter material used and its activation (or reactivation) requirements.

The Young's modulus (also defined as elastic modulus) measures the stiffness of a material, i.e., how much it will deform under a given load. A lower Young's modulus means the material is more flexible, whereas a higher value indicates a stiffer, less flexible material.

The ductility is a measure of how much a metal can elongate or deform before breaking, and it is expressed as the percentage of elongation or the reduction in area after a tensile test. The yield strength is the resistance to deformation and it is expressed as the maximum stress, measured in MPa, that can be applied to a material before it changes shape permanently .

The metallic base 1 is characterized by a thickness comprised between 0.1 and 0.8 mm, which can also be not uniform over the area of base 1, a Young's modulus comprised between 45 and 230 GPa, a yield strength comprised between 100 and 500 MPa and a ductility comprised between 25 and 50%. Yield strength is measured by means of the standard stress-strain curve method and the value of a material is determined as the stress at which there is a permanent strain of 0,2%. Young's modulus is determined as the ratio between stress and strain values under elastic conditions (i.e. in the linear part of the stress-strain curve). Ductility is measured in a tensile test as the percent elongation at break, i.e. the percentage of the difference between length of the material after fracture and original length with respect to the original length.

Suitable materials for the metallic base according to the invention can be selected in the group consisting of stainless steel series (i.e. SS304L, SS301, 316L, 316Ti, etc.), NiCroFer, Nichrome, plated iron, plated Kovar, nickel and titanium.

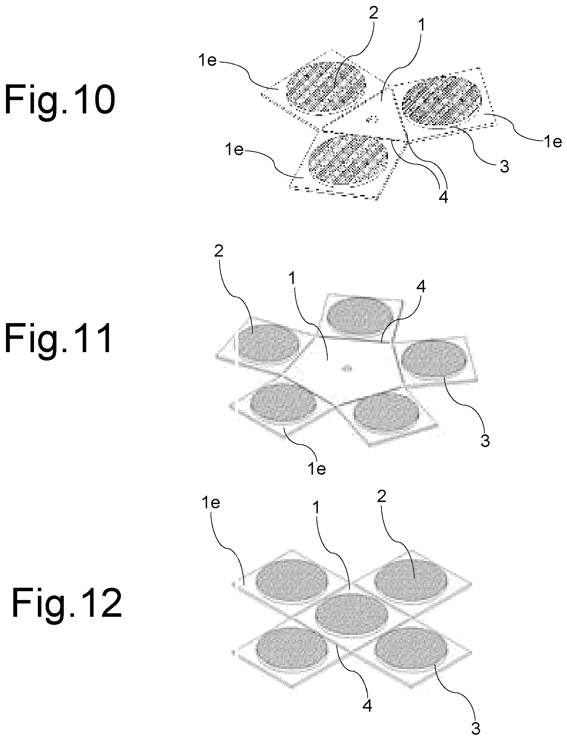

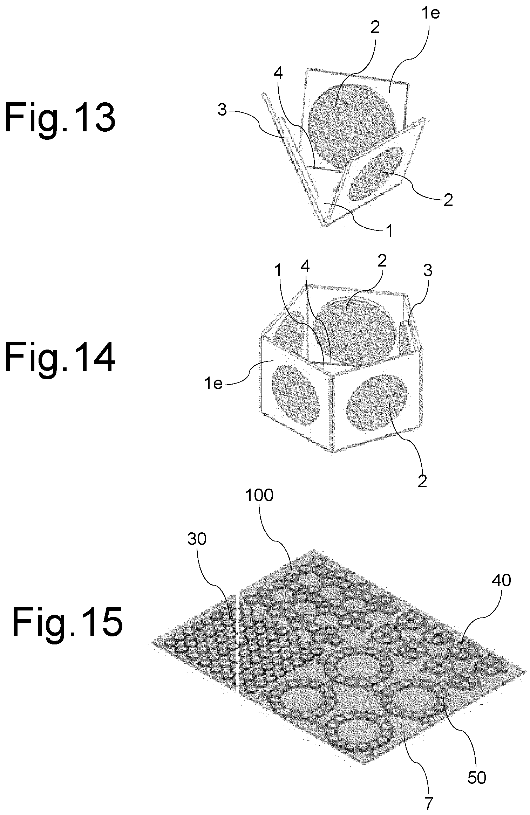

Due to the careful choice of the material parameters of base 1 and the optional, although preferred, presence of grooves 4, a portion of base 1 with two consecutive units can be folded with an angle up to 180°. The base 1 can also be shaped so as to have a plurality of flap-like extensions 1e that can be folded along grooves 4 to form 3D structures, such as the circular "crown" of Fig.9 or the structures shown in figures 13, 14 obtained from the assemblies of figures 10, 11 respectively. Note that the central portion of base 1 with respect to which extensions 1e are folded can be either empty, as shown in figures 10 and 11, or carry a sorbing unit as in Fig.12.

In a preferred embodiment, the non-evaporable getter material 2 is exposed on both sides of base 1 to increase the absorbing surface, as shown in figures 8-14 for example. The non-evaporable getter material 2 is preferably prevented from exiting frame 3 by providing on one side of base 1 an inward-bent rim that reduces the cross-section of frame 3 to act as a peripheral stop, and on the other side a perforated plate or a mesh-like grid that acts as the bottom of frame 3.

In its undeformed shape, base 1 preferably has main linear dimensions comprised between 0.5 cm and 40 cm, most preferably comprised between 2 cm and 15 cm. It is noted that the base width may also be not uniform along the length of base 1.

As mentioned above, each frame 3 of the interconnected units is filled with powders of a non-evaporable getter material 2 which may be sintered to improve the mechanical strength, the resistance to shocks and vibrations and to minimize particle loss risks. In a preferred embodiment the non-evaporable getter alloy powder is selected among the following compositions: ZrVFe alloys, ZrCoRareEarths alloys, ZrAl alloys, ZrVAlTi alloys, TiVA1FeSi alloys, ZrFe alloys, ZrVFe and Ti mixtures, ZrAl and Ti mixtures, ZrAl and Zr mixtures, ZrVAl and Zr mixtures, and more preferably ZrVFe and Zr mixtures, ZrFeVMnRareEarths alloys, ZrVFeY alloys, ZrVAl alloys, ZrVAl and Ti mixtures, TiMo compounds , ZrC compounds.

Moreover, the non-evaporable getter powders are characterized by a good value of porosity comprised between 8 and 30%, defined as the percentage of open spaces or voids with respect to the total volume of the pressed getter powders, and, at the same time, by excellent mechanical resistance properties, demonstrating overall high absorption performance and at the same time very low particle loss.

In a preferred embodiment, frames 3 are connected to base 1 by means of electrical welding, laser welding, brazing, or soldering.

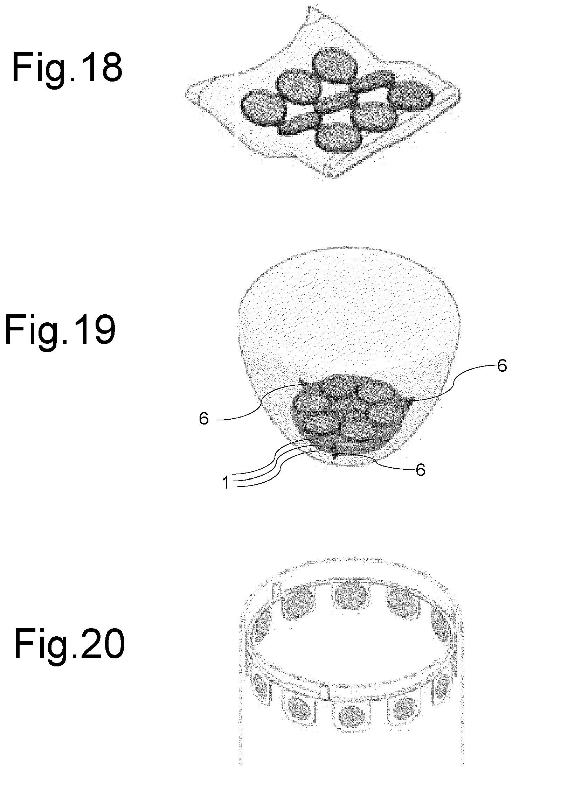

When required, two or more getter assemblies can be superimposed on each other in order to maximize the mass of getter material in specific positions of the systems; in this case the assemblies can be connected together mechanically through the coupling means 5 or through additional connectors such as the C-shaped clips 6 in figures 7 and 19. As an alternative or an addition to the mechanical connection, it is possible to place in contact the getter surfaces of the getter units and join them through a metallic binder, compatible with the getter and containing titanium powder or other sintering powder, and then applying a sintering treatment to consolidate the stack structure.

Optionally, other getter parts can be connected to the getter units by means of the metallic binder and sintering treatment. According to a preferred embodiment of the present invention, said connection means are suitable to increase the getter mass of the getter units or to combine ancillary parts, for example also including parts with resistive elements that can be used as heaters for the getter activation, directly on the getter units.

According to a further embodiment, the getter assembly herein disclosed can integrate an internal or external heater (not shown) which can ease the getter activation. In said configuration an electrical insulation is preferably arranged between the getter units and the heater, which can consist in a resistive element with high resistance (for example a long filiform element or a long strip of Mo or of MoRe) that can be easily heated even at high temperatures (well above 500°C) by passing current through it. The heater can be also embedded in the getter unit, or can be used as a support and heating element of the getter unit, to obtain an active getter unit that can be easily activated and that can also contribute to the thermal activation of the surrounding units.

In a preferred embodiment, the heater is insulated from the getter powder and from the metallic structure with a dielectric coating, for example a suitable oxide coating or a nitride coating, such as Al₂O₃ coating, AlN coating, Zr₂O coating.

The getter assembly of the present invention can be used in vacuum electron tubes, vacuum insulated devices, sensors with vacuum jackets, MEMs, in discharge lamps with vacuum or gas filled jackets, hermetically sealed electronic and optoelectronic systems and in particular in all the systems under vacuum or with inert/N₂ filling gas that may need an easy integration of a modular getter.

The flexible metallic bases 1 carrying at least two interconnected sorbing units are usually preassembled before the mounting inside the apparatus: in this way it is possible to reduce the time and the work necessary to integrate the assemblies in the vacuum system, also minimizing the risks to introduce undesired contaminations in it.

In a preferred embodiment, preassembled assemblies in 2D form, with already mounted getter units, are supported on or connected to foils or sheets 7 in a kit for easy handling and shipment. Even more preferably, the supporting foil or sheet 7 itself is made of the metal used for the flexible metallic bases 1 and the getter units are mounted thereon, then cuts are made along the perimeters of the getter assemblies leaving only small portions uncut to hold the assemblies onto the foil or sheet 7.

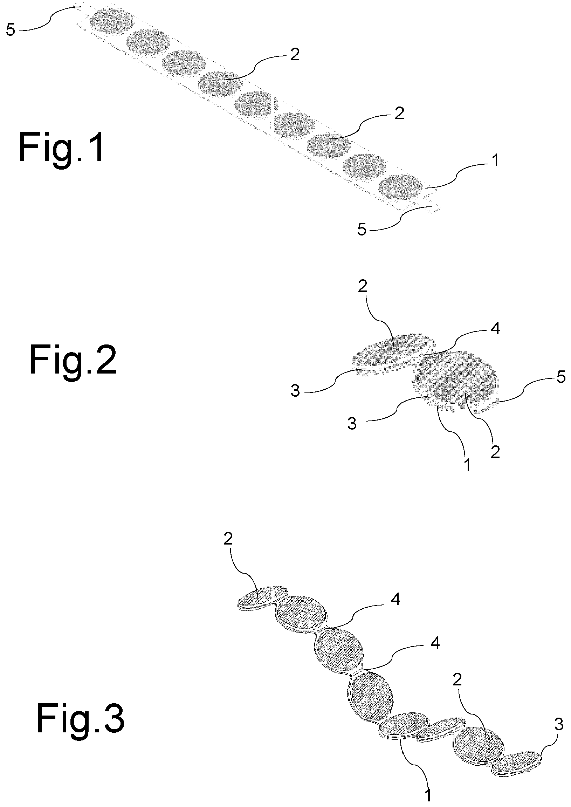

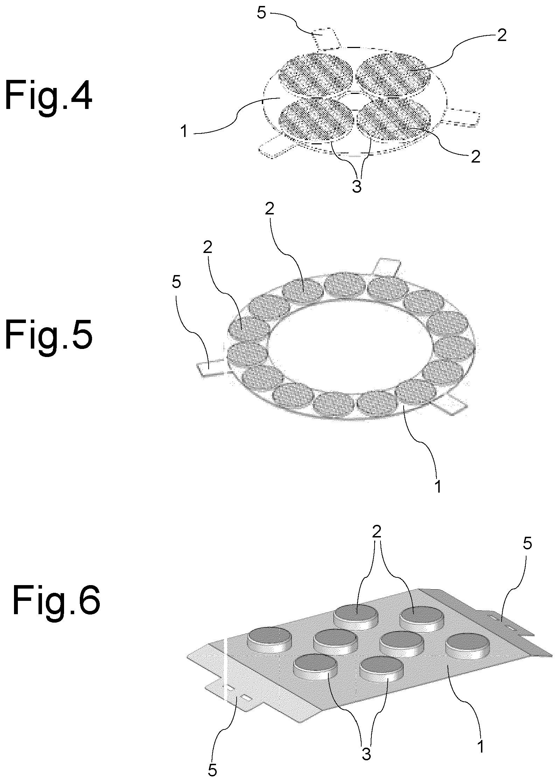

In the example shown in Fig.15, more specifically, a metallic sheet 7 contains eight assemblies 30 of the type shown in Fig.3, eight assemblies 40 of the type shown in Fig.4, four assemblies 50 of the type shown in Fig.5 and twelve assemblies 100 of the type shown in Fig.10. When necessary, these assemblies can be easily detached from the metallic sheet 7, can be shaped according to the final custom design and easily integrated in the apparatus. The remainder of sheet 7 with the holes where the bases 1 have been removed can be recycled once all the getter assemblies of the kit have been used.

### EXAMPLES

Hereinafter, the invention will be explained in more detail with reference to the following non-limiting examples. Modifications or variations of the embodiments here exemplified, obvious to an expert in the art, are encompassed by the appended claims.

Tests have been carried out on simple modular getters made with flexible structures in accordance with the invention (samples S1-S4) and with flexible structures not in accordance with the invention (comparative samples C1-C3). In all the samples the base had a uniform thickness.

Tests have been conducted heating the getter structures at 500°C for about 1 minute to check the resistance of the structures to a moderate activation treatment (applicable on getter materials with low temperature activation characteristics) and to check any residual shape distortion after the heating cycle.

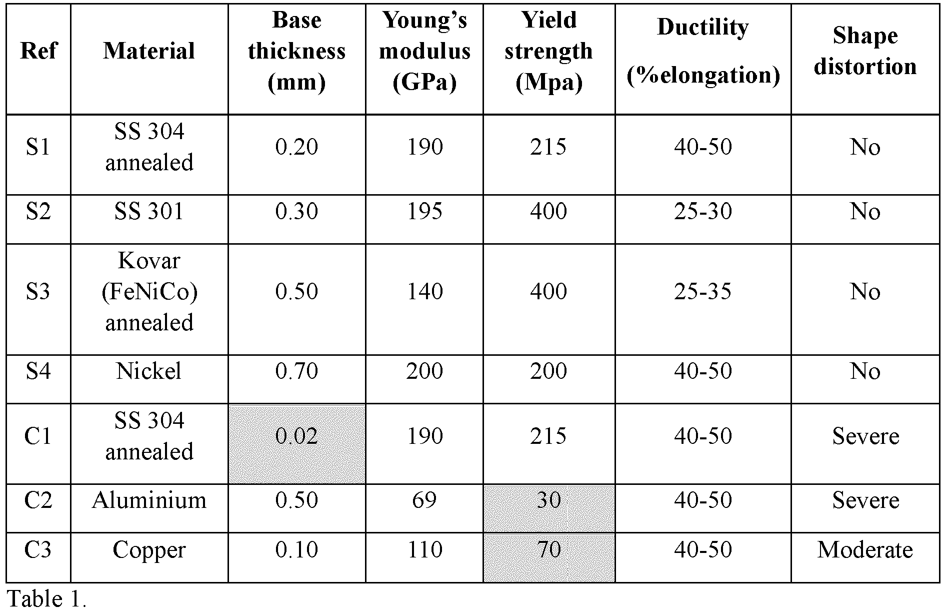

A severe distortion means that the final shape, size and position of the getter assembly after the thermal treatment are different from the original one with the sorbing units varying their reciprocal distance, whereas a moderate distortion is related to a shape change or structure twisting but with the sorbing units essentially maintaining their reciprocal distance. Table 1 clearly shows that only the flexible structures which fulfill all the parameters according to the invention can withstand the applied activation treatment maintaining their shape and position (see S1-S4). On the contrary, when one of the parameters is not comprised in the claimed ranges (highlighted in gray: C1 for the base thickness, C2-C3 for the yield strength) the structures of the getter assembly deform, with consequent damages to the devices containing them.

## Claims

1. A modular getter assembly comprising a flexible metallic base (1) carrying at least two sorbing units connected thereto, wherein each of said sorbing units includes a frame (3) filled with a compressed powder of a non-evaporable getter material (2), **characterized in that** said flexible metallic base (1) has a thickness comprised between 0.1 and 0.8 mm and is made of a material having:
- a Young's modulus comprised between 45 and 230 GPa,
- a yield strength comprised between 100 and 500 MPa, and
- a ductility comprised between 25 and 50%.

2. A modular getter assembly according to claim 1, wherein the base (1) is a structure with one or more degrees of freedom, preferably obtained through grooves (4) located between the sorbing units and/or between the sorbing units and coupling elements (5) through which the assembly can be connected to other assemblies and/or to the apparatus which requires the getter activity, wherein said grooves (4) are **characterized by**:
- a groove depth D comprised between 40% and 100% of the base thickness and
- a groove extension E comprised between 20% and 100% of the base width,
- wherein the sum of depth D and extension E is comprised between 60% and 180%.

3. A modular getter assembly according to claim 1 or 2, wherein the base (1) is provided with at least two coupling elements (5) through which the assembly can be connected to other assemblies and/or to the apparatus which requires the getter activity.

4. A modular getter assembly according to any of the previous claims, wherein the base (1) has an undeformed configuration with main linear dimensions comprised between 0.5 cm and 40 cm, preferably comprised between 2 cm and 15 cm.

5. A modular getter assembly according to any of the previous claims, wherein the volume of each frame (3) is comprised between 2 mm³ and 200 mm³, preferably between 2.5 mm³ and 100 mm³.

6. A modular getter assembly according to any of the previous claims, wherein the frames (3) of the sorbing units have a circular, oval, rectangular, squared, or general polygonal shape.

7. A modular getter assembly according to any of the previous claims, wherein the non-evaporable getter material (2) has a composition selected in the group consisting of ZrVFe alloys, ZrVFeY alloys, ZrCoRareEarths alloys, ZrAl alloys, ZrVAl alloys, ZrVFeMnRareEarths alloys, ZrVAlTi alloys, TiVAlFeSi alloys, ZrFe alloys, TiMo compounds , ZrC compounds, ZrVFe and Ti mixtures, ZrAl and Ti mixtures, ZrVFe and Zr mixtures, ZrAl and Zr mixtures, ZrVAl and Ti mixtures, ZrVAl and Zr mixtures.

8. A modular getter assembly according to any of the previous claims, wherein the non-evaporable getter powder compressed in the sorbing units has a porosity comprised between 8 and 30%.

9. A modular getter assembly according to any of the previous claims, wherein the non-evaporable getter material (2) is a sintered powder.

10. A modular getter assembly according to any of the previous claims, wherein the base (1) is made of a material selected in the group consisting of stainless steel series, NiCroFer, Nichrome, plated iron, plated Kovar, nickel and titanium.

11. A modular getter assembly according to any of the previous claims, wherein the frames (3) are connected to the base (1) by electrical welding, laser welding, brazing, or soldering.

12. A modular getter assembly according to any of the previous claims, further comprising at least one heater.

13. A getter kit structure comprising multiple getter assemblies (30, 40, 50, 100) according to any of claims 1 to 12 connected to a supporting sheet or foil (7).

14. A getter kit according to claim 13, comprising additional ancillary units such as electrically insulating parts, thermally insulating parts, shielding parts, feedthroughs, mechanical fixing parts.

15. Use of a getter assembly according to any of claims 1 to 12 in vacuum electron tubes, vacuum insulated devices, sensors with vacuum jackets, MEMs, discharge lamps with vacuum or gas-filled jackets, or hermetically sealed electronic and optoelectronic systems.

## Patentansprüche

1. Modulare Getter-Anordnung, umfassend eine flexible metallische Basis (1), die mindestens zwei daran angeschlossene sorbierende Einheiten trägt, wobei jede der sorbierenden Einheiten einen Rahmen (3) einschließt, der mit einem komprimierten Pulver eines nicht verdampfbaren Getter-Materials (2) gefüllt ist, **dadurch gekennzeichnet, dass** die flexible metallische Basis (1) eine Dicke aufweist, die zwischen 0,1 und 0,8 mm liegt, und aus einem Material hergestellt ist, das aufweist:
- einen Elastizitätsmodul, der zwischen 45 und 230 Gpa liegt,
- eine Streckgrenze, die zwischen 100 und 500 Mpa liegt, und
- eine Duktilität, die zwischen 25 und 50 % liegt.

2. Modulare Getter-Anordnung nach Anspruch 1, wobei die Basis (1) eine Struktur mit einem oder mehreren Freiheitsgraden ist, vorzugsweise über Nuten (4) erhalten, die zwischen den sorbierenden Einheiten und/oder zwischen den sorbierenden Einheiten und Kopplungselementen (5) gelegen sind, über die die Anordnung an andere Anordnungen und/oder an die Vorrichtung angeschlossen werden kann, die die Getter-Aktivität erfordert, wobei die Nuten (4) **gekennzeichnet sind durch:**
- eine Nuttiefe D, die zwischen 40 % und 100 % der Basisdicke liegt, und
- eine Nutenerweiterung E, die zwischen 20 % und 100 % der Basisbreite liegt,
- wobei die Summe aus Tiefe D und Erstreckung E zwischen 60 % und 180 % liegt.

3. Modulare Getter-Anordnung nach Anspruch 1 oder 2, wobei die Basis (1) mit mindestens zwei Kopplungselementen (5) bereitgestellt wird, über die die Anordnung an andere Anordnungen und/oder an die Vorrichtung angeschlossen werden kann, die die Getter-Aktivität erfordert.

4. Modulare Getter-Anordnung nach einem der vorstehenden Ansprüche, wobei die Basis (1) eine unverformte Konfiguration mit hauptsächlichen linearen Abmessungen, die zwischen 0,5 cm und 40 cm liegen, vorzugsweise zwischen 2 cm und 15 cm liegen, aufweist.

5. Modulare Getter-Anordnung nach einem der vorstehenden Ansprüche, wobei das Volumen jedes Rahmens (3) zwischen 2 mm³ und 200 mm³, vorzugsweise zwischen 2,5 mm³ und 100 mm³ liegt.

6. Modulare Getter-Anordnung nach einem der vorstehenden Ansprüche, wobei die Rahmen (3) der sorbierenden Einheiten eine kreisförmige, ovale, rechteckige, quadratische oder allgemein polygonale Form aufweisen.

7. Modulare Getter-Anordnung nach einem der vorstehenden Ansprüche, wobei das nicht verdampfbare Getter-Material (2) eine Zusammensetzung aufweist, die in der Gruppe ausgewählt ist, bestehend aus ZrVFe-Legierungen, ZrVFeY-Legierungen, ZrCoSeltenerdlegierungen, ZrAl-Legierungen, ZrVAl-Legierungen, ZrVFeMnSeltenenerdlegierungen, ZrVAlTi-Legierungen, TiVAlFeSi-Legierungen, ZrFe-Legierungen, TiMo-Verbindungen, ZrC-Verbindungen, ZrVFe- und Ti-Mischungen, ZrAl- und Ti-Mischungen, ZrVFe- und Zr-Mischungen, ZrAl- und Zr-Mischungen, ZrVAl- und Ti-Mischungen, ZrVAl- und Zr-Mischungen.

8. Modulare Getter-Anordnung nach einem der vorstehenden Ansprüche, wobei das nicht verdampfbare Getter-Pulver, das in den sorbierenden Einheiten komprimiert ist, eine Porosität aufweist, die zwischen 8 und 30 % liegt.

9. Modulare Getter-Anordnung nach einem der vorstehenden Ansprüche, wobei das nicht verdampfbare Getter-Material (2) ein gesintertes Pulver ist.

10. Modulare Getter-Anordnung nach einem der vorstehenden Ansprüche, wobei die Basis (1) aus einem Material hergestellt ist, das in der Gruppe ausgewählt ist, bestehend aus Edelstahlserien, NiCroFer, Nichrom, plattiertem Eisen, plattiertem Kovar, Nickel und Titan.

11. Modulare Getter-Anordnung nach einem der vorstehenden Ansprüche, wobei die Rahmen (3) an die Basis (1) durch elektrisches Schweißen, Laserschweißen, Hartlöten oder Weichlöten angeschlossen sind.

12. Modulare Getter-Anordnung nach einem der vorstehenden Ansprüche, ferner umfassend mindestens einen Heizapparat.

13. Getter-Kit-Struktur, umfassend mehrere Getter-Anordnungen (30, 40, 50, 100) nach einem der Ansprüche 1 bis 12, die mit einem Stützbogen oder einer Stützfolie (7) verbunden sind.

14. Getter-Kit nach Anspruch 13, umfassend zusätzliche Hilfseinheiten wie elektrisch isolierende Teile, thermisch isolierende Teile, Abschirmteile, Durchkontaktierungen, mechanische Befestigungsteile.

15. Verwendung einer Getter-Anordnung nach einem der Ansprüche 1 bis 12 in Vakuumelektronenröhren, vakuumisolierten Einrichtungen, Sensoren mit Vakuummänteln, MEMs, Entladungslampen mit Vakuum- oder gasgefüllten Mänteln oder hermetisch abgedichteten elektronischen und optoelektronischen Systemen.

## Revendications

1. Ensemble getter modulaire comprenant une base métallique flexible (1) contenant au moins deux unités de sorption reliées à celle-ci, dans lequel chacune desdites unités de sorption comporte un cadre (3) rempli d'une poudre comprimée d'un matériau getter non évaporable (2), **caractérisé en ce que** ladite base métallique flexible (1) a une épaisseur comprise entre 0,1 et 0,8 mm et est constituée d'un matériau ayant :
- un module de Young compris entre 45 et 230 GPa,
- une limite d'élasticité comprise entre 100 et 500 MPa, et
- une ductilité comprise entre 25 et 50 %.

2. Ensemble getter modulaire selon la revendication 1, dans lequel la base (1) est une structure avec un ou plusieurs degrés de liberté, de préférence obtenus au moyen de rainures (4) situées entre les unités de sorption et/ou entre les unités de sorption et des éléments d'accouplement (5) au moyen desquels l'ensemble peut être relié à d'autres ensembles et/ou à l'appareil qui requiert l'activité getter, dans lequel lesdites rainures (4) sont **caractérisées par :**
- une profondeur de rainure D comprise entre 40 % et 100 % de l'épaisseur de la base et
- une extension de rainure E comprise entre 20 % et 100 % de la largeur de la base,
- dans lequel la somme de la profondeur D et de l'extension E est comprise entre 60 % et 180 %.

3. Ensemble getter modulaire selon la revendication 1 ou 2, dans lequel la base (1) est pourvue d'au moins deux éléments d'accouplement (5) au moyen desquels l'ensemble peut être relié à d'autres ensembles et/ou à l'appareil qui requiert l'activité getter.

4. Ensemble getter modulaire selon l'une quelconque des revendications précédentes, dans lequel la base (1) a une configuration non déformée avec des dimensions linéaires principales comprises entre 0,5 cm et 40 cm, de préférence comprises entre 2 cm et 15 cm.

5. Ensemble getter modulaire selon l'une quelconque des revendications précédentes, dans lequel le volume de chaque cadre (3) est compris entre 2 mm³ et 200 mm³, de préférence entre 2,5 mm³ et 100 mm³.

6. Ensemble getter modulaire selon l'une quelconque des revendications précédentes, dans lequel les cadres (3) des unités de sorption ont une forme circulaire, ovale, rectangulaire, carrée, ou polygonale générale.

7. Ensemble getter modulaire selon l'une quelconque des revendications précédentes, dans lequel le matériau getter non évaporable (2) a une composition choisie dans le groupe constitué d'alliages Zr-V-Fe, alliages Zr-V-Fe-Y, alliages Zr-Co-terres rares, alliages Zr-AI, alliages Zr-V-Al, alliages Zr-V-Fe-Mn-terres rares, alliages Zr-V-Al-Ti, alliages Ti-V-Al-Fe-Si, alliages Zr-Fe, composés Ti-Mo, composés Zr-C, mélanges Zr-V-Fe et Ti, mélanges Zr-Al et Ti, mélanges Zr-Al et Ti, mélanges Zr-V-Fe et Zr, mélanges Zr-Al et Zr, mélanges Zr-V-Al et Ti, mélanges Zr-V-Al et Zr.

8. Ensemble getter modulaire selon l'une quelconque des revendications précédentes, dans lequel la poudre getter non évaporable comprimée dans les unités de sorption a une porosité comprise entre 8 et 30 %.

9. Ensemble getter modulaire selon l'une quelconque des revendications précédentes, dans lequel le matériau getter non évaporable (2) est une poudre frittée.

10. Ensemble getter modulaire selon l'une quelconque des revendications précédentes, dans lequel la base (1) est faite d'un matériau choisi dans le groupe constitué de séries d'acier inoxydable, Ni-Cro-Fer, Nichrome, fer plaqué, Kovar plaqué, nickel et titane.

11. Ensemble getter modulaire selon l'une quelconque des revendications précédentes, dans lequel les cadres (3) sont reliés à la base (1) par soudage électrique, soudage au laser, brasage, ou soudure.

12. Ensemble getter modulaire selon l'une quelconque des revendications précédentes, comprenant en outre au moins un élément chauffant.

13. Structure de kit getter comprenant de multiples ensembles getter (30, 40, 50, 100) selon l'une quelconque des revendications 1 à 12 reliés à une feuille ou un film de support (7).

14. Kit getter selon la revendication 13, comprenant des unités auxiliaires supplémentaires telles que des pièces électriquement isolantes, des pièces thermiquement isolantes, des pièces de blindage, des traversées, des pièces de fixation mécanique.

15. Utilisation d'un ensemble getter selon l'une quelconque des revendications 1 à 12 dans des tubes électroniques à vide, des dispositifs isolés à vide, des capteurs avec des enveloppes à vide, des MEM, des lampes à décharge avec des enveloppes à vide ou remplies de gaz, ou des systèmes électroniques et optoélectroniques scellés hermétiquement.
